# EUROPÄISCHE PATENTSCHRIFT

(11) **EP 3 259 789 B1**
(45) Veröffentlichungstag und Bekanntmachung des Hinweises auf die Patenterteilung: **11.12.2019**
(21) Anmeldenummer: 16704263.9
(22) Anmeldetag: 15.02.2016
(51) Int. Cl.: H01M 2/10, H01M 10/48, H01M 10/42, H01M 2/02, H01M 10/06, G01R 31/396

(54) **ÜBERWACHEN EINER ZUSTANDSGRÖSSE WENIGSTENS EINER BATTERIEZELLE EINER BATTERIE**
MONITORING A STATE VARIABLE OF AT LEAST ONE BATTERY CELL OF A BATTERY
SURVEILLANCE D'UNE GRANDEUR D'ÉTAT D'AU MOINS UN ÉLÉMENT D'UNE BATTERIE

(30) Priorität: 18.02.2015 DE 102015002150
(43) Veröffentlichungstag der Anmeldung: 27.12.2017
(73) Patentinhaber: Audi AG, 85045 Ingolstadt (DE)
(72) Erfinder: HINTERBERGER, Michael, 85055 Ingolstadt (DE); HELLENTHAL, Berthold, 90596 Schwanstetten (DE)
(86) Internationale Anmeldenummer: PCT/EP2016/053178
(87) Internationale Veröffentlichungsnummer: WO 2016/131779

(56) Entgegenhaltungen:
- DE-A1-102009 000 336
- DE-A1-102012 113 078
- DE-A1-102013 203 104
- US-A1- 2011 234 166

## Beschreibung

Die vorliegende Erfindung betrifft ein Verfahren zum Überwachen einer Zustandsgröße wenigstens einer Batteriezelle einer Batterie, wobei die Batterie wenigstens zwei benachbart zueinander angeordnete Batteriezellen aufweist. Die Erfindung betrifft auch eine Überwachungseinrichtung zum Überwachen einer Zustandsgröße wenigstens einer Batteriezelle einer Batterie, wobei die Batterie wenigstens zwei benachbart zueinander angeordnete Batteriezellen aufweist. Weiterhin betrifft die Erfindung eine Batterie mit wenigstens zwei benachbart zueinander angeordneten Batteriezellen sowie auch ein Kraftfahrzeug mit einer elektrischen Antriebsvorrichtung und mit einer an die elektrische Antriebsvorrichtung angeschlossenen elektrischen Anlage zum Versorgen der elektrischen Antriebsvorrichtung mit elektrischer Energie, die eine Batterie aufweist, die wenigstens zwei benachbart zueinander angeordnete Batteriezellen aufweist.

Verfahren zum Überwachen einer Zustandsgröße wenigstens einer Batteriezelle einer Batterie sowie Überwachungsvorrichtungen hierfür sind dem Grunde nach bekannt, sodass es eines gesonderten druckschriftlichen Nachweises hierfür nicht bedarf. Solche Batteriezellen beziehungsweise Batterien werden häufig bei Hochvoltbatteriesystemen eingesetzt, wie sie zum Beispiel bei elektrisch antreibbaren Fahrzeugen oder dergleichen verwendet werden. Aktuell werden während der Herstellung von Batteriezellen sowie hieraus gebildeten Batterien unterschiedliche Qualitätsprüfungen durchgeführt, beispielsweise eine Isolationsmessung, eine Spannungsfestigkeitsmessung und/oder dergleichen. Darüber hinaus verfügen Hochvoltbatteriesysteme häufig über eine Isolationsüberwachungseinrichtung zur aktiven Isolationsprüfung des Hochvoltbatteriesystems. Diese Einrichtung prüft sowohl einen Hochvolt-Plus-Anschluss als auch einen Hochvolt-Minus-Anschluss gegenüber einer Masse einer Vorrichtung wie zum Beispiel das Kraftfahrzeug, die die Hochvoltbatterie umfasst. Bei Anwendung der Hochvoltbatterie in einem Kraftfahrzeug wird die Isolation in Bezug auf eine Kraftfahrzeugmasse überwacht.

Ebenso sind entsprechende Batterien aus dem Stand der Technik bekannt, die aus wenigstens zwei Batteriezellen gebildet sind.

Eine Batteriezelle ist eine Einrichtung, die zwei Elektroden aufweist, die elektrochemisch miteinander wechselwirken. Das Wechselwirken kann unter ergänzender vermittelnder Wirkung eines Elektrolyten erfolgen. Batteriezellen, auch galvanische Zellen genannt, sind vorzugsweise reversibel hinsichtlich ihrer Funktion, wie sie beispielsweise bei Batterien in Form von Akkumulatoren oder dergleichen zum Einsatz kommen. Aufgrund der elektrochemischen Wechselwirkung der Elektroden stellt sich an den Elektroden eine für die jeweilige batteriezellenchemiespezifische Gleichspannung ein, die an den Elektroden verbundenen Anschlusskontakten der jeweiligen Batteriezelle bereitgestellt ist.

Diese Gleichspannung ist in der Regel vergleichsweise klein. Viele Anwendungen in der Elektrotechnik erfordern eine Gleichspannung, die die Gleichspannung, die durch eine einzelne Batteriezelle bereitgestellt werden kann, deutlich überschreitet. Aus diesem Grund ist häufig eine Mehrzahl von Batteriezellen zu einer Batterie zusammengefasst und entsprechend der elektrischen Anforderungen innerhalb der Batterie elektrisch verschaltet, beispielsweise in Form einer Reihenschaltung, einer Parallelschaltung, Kombinationen hiervon oder dergleichen.

Innerhalb der Batterie sind die einzelnen Batteriezellen deshalb mittels Stromschienen oder dergleichen elektrischer Leiter in der gewünschten Schaltungsart miteinander elektrisch leitend verbunden, um an Anschlusspolen der Batterie die gewünschte Gleichspannung bereitstellen zu können. Solche Batterien werden beispielsweise als Blei-Säurebatterien im Kraftfahrzeugbereich, als Nickel-Kadmium-Batterien im Flugzeugbereich und bei unterbrechungsfreien Stromversorgungen, als Lithium-Ionen-Batterien im Bereich von Haushaltskleingeräten und/oder dergleichen, neuerdings aber auch bei elektrisch angetriebenen Fahrzeugen angewendet.

Kraftfahrzeuge der gattungsgemäßen Art sind ebenfalls hinlänglich bekannt. Vorzugsweise umfasst sind Kraftfahrzeuge, die eine elektrische Anlage mit einer Batterie sowie eine an die elektrische Anlage angeschlossene Antriebsvorrichtung aufweisen. Solche Kraftfahrzeuge sind beispielsweise Elektrofahrzeuge, Hybridfahrzeuge, bei denen ein Antrieb sowohl mittels einer elektrischen Antriebsvorrichtung als auch mittels einer Verbrennungskraftmaschine möglich ist, oder dergleichen. Bei diesen Fahrzeugen weisen die Batterie und die Antriebsvorrichtung jeweils wenigstens zwei elektrische Anschlusskontakte auf. Zum Zwecke der elektrischen Kopplung sind wenigstens einer der Anschlusskontakte der Batterie und einer der Anschlusskontakte der Antriebsvorrichtung mittels einer elektrischen Leitung elektrisch leitend miteinander verbunden.

Beim Betrieb von Batteriezellen beziehungsweise Batterien der gattungsgemäßen Art können Probleme insbesondere hinsichtlich des bestimmungsgemäßen Betriebs, der Alterung und/oder dergleichen auftreten. Dies kann die Qualität der Batteriezellen beziehungsweise der Batterie beeinträchtigen.

Es offenbart die DE 10 2009 000 336 A1 eine Impedanzmessung von elektrochemischen Energiespeichern in Kraftfahrzeugen.

Es ist die Aufgabe der Erfindung, ein Verfahren zum Überwachen einer Zustandsgröße wenigstens einer Batteriezelle einer Batterie, eine Überwachungseinrichtung hierfür, eine Batterie sowie ein Kraftfahrzeug mit einer Batterie anzugeben, bei denen auf einfache Weise und genau eine Qualitätsaussage bezüglich der Batteriezelle beziehungsweise der aus den Batteriezellen gebildeten Batterie ermöglicht werden kann.

Als Lösung werden mit der Erfindung ein Verfahren, eine Überwachungsvorrichtung, eine Batterie sowie auch ein Kraftfahrzeug gemäß den unabhängigen Ansprüchen vorgeschlagen.

Weitere vorteilhafte Ausgestaltungen der Erfindung ergeben sich anhand von Merkmalen der abhängigen Ansprüche.

Mit der Erfindung wird für ein gattungsgemäßes Verfahren insbesondere vorgeschlagen, dass es folgende Schritte umfasst:
- Vorsehen von einer ersten elektrisch leitfähigen Fläche an einer Begrenzungsfläche einer ersten der wenigstens zwei Batteriezellen und Vorsehen einer zweiten elektrisch leitfähigen Fläche an einer Begrenzungsfläche einer zweiten der wenigstens zwei Batteriezellen, wobei die elektrisch leitfähigen Flächen elektrisch isoliert voneinander angeordnet werden,
- Anlegen einer elektrischen Spannung zwischen den beiden elektrisch leitfähigen Flächen,
- Auswerten einer aufgrund einer Einwirkung der elektrischen Spannung erzeugten elektrischen Größe, und
- Ermitteln der Zustandsgröße aufgrund des Auswertens.

Bezüglich einer Überwachungseinrichtung wird insbesondere vorgeschlagen, dass die Überwachungseinrichtung ausgebildet ist, eine elektrische Spannung zwischen einer ersten elektrisch leitfähigen Fläche, die an einer Begrenzungsfläche einer ersten der wenigstens zwei Batteriezellen vorgesehen ist und einer zweiten elektrisch leitfähigen Fläche, die an einer Begrenzungsfläche einer zweiten der wenigstens zwei Batteriezellen vorgesehen ist, anzulegen, eine aufgrund einer Einwirkung der elektrischen Spannung erzeugte elektrische Größe auszuwerten und die Zustandsgröße aufgrund des Auswertens zu ermitteln.

Batterieseitig wird insbesondere vorgeschlagen, dass eine Begrenzungsfläche einer ersten der wenigstens zwei Batteriezellen eine erste elektrisch leitfähige Fläche und eine Begrenzungsfläche einer zweiten der wenigstens zwei Batteriezellen eine zweite elektrisch leitfähige Fläche aufweist, wobei die elektrisch leitfähigen Flächen elektrisch isoliert voneinander angeordnet sind, wobei die Batterie eine Überwachungseinrichtung aufweist, die ausgebildet ist, eine elektrische Spannung zwischen den beiden elektrisch leitfähigen Flächen anzulegen, eine aufgrund einer Einwirkung der elektrischen Spannung erzeugte elektrische Größe auszuwerten und die Zustandsgröße aufgrund des Auswertens zu ermitteln.

Kraftfahrzeugseitig wird insbesondere vorgeschlagen, dass eine Begrenzungsfläche einer ersten der wenigstens zwei Batteriezellen eine erste elektrisch leitfähige Fläche und eine Begrenzungsfläche einer zweiten der wenigstens zwei Batteriezellen eine zweite elektrisch leitfähige Fläche aufweist, wobei die elektrisch leitfähigen Flächen elektrisch isoliert voneinander angeordnet sind, wobei die Batterie eine Überwachungseinrichtung aufweist, die ausgebildet ist, eine elektrische Spannung zwischen den beiden elektrisch leitfähigen Flächen anzulegen, eine aufgrund der Einwirkung der elektrischen Spannung erzeugte elektrische Größe auszuwerten und die Zustandsgröße aufgrund des Auswertens zu ermitteln.

Die Erfindung nutzt die Erkenntnis, dass beispielsweise ein Isolationsmaterial der Batterie beziehungsweise der Batteriezelle einer Alterung unterliegen kann. Darüber hinaus kann die Batteriezelle beziehungsweise die Batterie in Abhängigkeit der Alterung und des jeweiligen Betriebszustands auch seine geometrischen Abmessungen verändern. Beispielsweise tritt unter anderem bei Lithium-Ionen-Batterien eine Volumenerhöhung mit zunehmender Alterung und/oder auch in Abhängigkeit des Ladezustands der Batterie auf. Bei prismatischen Batteriezellen kann sich dies in Form eines Ausbauchverhaltens zeigen. Dies kann unter anderem auf eine Veränderung des Isolationsmaterials zwischen den benachbarten Batteriezellen über die Lebensdauer hinweg auftreten.

Die Zustandsgröße ist vorzugsweise eine den Qualitätszustand der Batteriezelle beziehungsweise der Batterie kennzeichnende Zustandsgröße, beispielsweise ein Alterungszustand, ein Kapazitätszustand, Abmessungen der Batteriezellen beziehungsweise der Batterie und/oder dergleichen. Darüber hinaus kann die Zustandsgröße natürlich auch eine Leerlaufspannung der jeweiligen Batteriezellen beziehungsweise der Batterie, ein Ladungszustand der Batterie, insbesondere der einzelnen Batteriezellen der Batterie und/oder dergleichen sein. Weiterhin kann die Zustandsgröße auch eine Temperatur, insbesondere der Batteriezelle, ein Druck, insbesondere in der Batteriezelle und/oder dergleichen sein.

Die Batteriezellen der Batterie sind benachbart zueinander angeordnet, vorzugsweise grenzen sie unmittelbar aneinander.

Die Erfindung basiert auf der weiteren Erkenntnis, dass das Ändern der Zustandsgröße sich auf die Geometrie der Batteriezelle beziehungsweise der Batterie auswirkt. Diese Änderung der Geometrie kann mittels elektrisch leitfähiger Flächen an Begrenzungsflächen der jeweiligen Batteriezellen kapazitiv ermittelt werden. Zu diesem Zweck sieht die Erfindung vor, dass eine erste elektrisch leitfähige Fläche an einer Begrenzungsfläche einer ersten der wenigstens zwei Batteriezellen und eine zweite elektrisch leitfähige Fläche an einer Begrenzungsfläche einer zweiten der wenigstens zwei Batteriezellen vorgesehen werden. Die elektrisch leitfähigen Flächen werden elektrisch isoliert voneinander angeordnet. Dadurch wird eine elektrische Kapazität geschaffen, die, wie im Folgenden noch erläutert werden wird, dem Auswerten zum Zwecke des Ermittelns der Zustandsgröße dienen kann.

Die Anordnung der elektrisch leitfähigen Flächen kann beispielsweise durch eine Isolierfolie, eine Oxidschicht, eine Isolierscheibe, Kombinationen hiervon und/oder dergleichen elektrisch isoliert angeordnet sein. Die elektrisch isolierte Anordnung der ersten und der zweiten elektrisch leitfähigen Fläche zueinander erlaubt es, die elektrische Kapazität bereitzustellen und einen Wert der elektrischen Kapazität ermitteln zu können. Dabei ist es für die Erfindung nicht zwingend erforderlich, dass die beiden elektrisch leitfähigen Flächen gleich groß und/oder direkt gegenüberliegend zueinander angeordnet sind. Die elektrisch leitfähigen Flächen können hinsichtlich ihrer Größe und Form voneinander abweichen, aber auch gegenüber einander verschoben sein und/oder dergleichen.

Erfindungsgemäß wird an die beiden elektrisch leitfähigen Flächen eine elektrische Spannung angelegt. Die elektrisch leitfähigen Flächen können diesbezüglich Anschlusskontakte oder dergleichen aufweisen, die es erlauben, einen entsprechenden Spannungsgenerator an die elektrisch leitfähigen Flächen anzuschließen.

Darüber hinaus kann natürlich vorgesehen sein, dass bei einer Mehrzahl von Batteriezellen vorzugsweise jede der Batteriezellen derartige elektrisch leitfähige Flächen aufweist, wobei eine Überwachungseinrichtung derart ausgebildet ist, dass sie unterschiedliche elektrisch leitfähige Flächen mit der elektrischen Spannung beaufschlagen kann. Dadurch ist es möglich, Vergleichswerte in Bezug auf andere Batteriezellen der Batterie zu erhalten und so eine Qualitätsaussage sowohl in Bezug auf die gesamte Batterie als auch in Bezug auf die einzelnen Batteriezellen zu erhalten.

Die elektrische Spannung kann beispielsweise ein Spannungsimpuls oder auch eine Spannungsimpulsfolge sein. Darüber hinaus kann die elektrische Spannung auch eine Wechselspannung, beispielsweise eine hochfrequente Wechselspannung, sein. Die Wechselspannung kann sowohl sinusförmig, rechteckförmig, dreieckförmig sowie als Kombinationen hiervon oder dergleichen ausgebildet sein. Natürlich kann auch der Spannungsimpuls eine Wechselspannung aufweisen. In dualer Weise kann dem Grunde nach natürlich auch ein Stromimpuls beziehungsweise ein Wechselstrom zur Beaufschlagung der elektrisch leitfähigen Flächen dienen. Dementsprechend würde der Spannungsgenerator durch einen Stromgenerator ersetzt.

Mittels einer Auswerteeinheit kann die Einwirkung der elektrischen Spannung auf eine durch die elektrische Spannung erzeugte elektrische Größe ermittelt werden. Vorzugsweise ist dies der elektrische Strom. Die Auswerteeinheit ermittelt zunächst einen Wert der durch die elektrisch leitfähigen Flächen gebildeten elektrischen Kapazität. Hieraus leitet die Auswerteeinheit unter vorteilhafter weiterer Berücksichtigung weiterer Parameter der Batteriezelle beziehungsweise der Batterie die jeweils gewünschte Zustandsgröße ab. Die weiteren Parameter können beispielsweise durch eine zelleninterne Sensorik, vorzugsweise in Verbindung mit einer geeigneten Auswerteeinheit, ermittelt werden. Die Auswerteeinheit steht zu diesem Zweck in Kommunikationsverbindung mit den weiteren Sensoreinheiten. Die weiteren Sensoreinheiten können beispielsweise eine Temperatur der Batteriezelle, einen Druck der Batteriezelle, eine Wichte eines Elektrolyten, eine Leerlaufspannung, einen Innenwiderstand und/oder dergleichen erfassen.

Besonders vorteilhaft erweist es sich, wenn die Auswerteeinheit die ermittelte Zustandsgröße mit zuvor bereits ermittelten Zustandsgrößen vergleichen kann. Darüber hinaus ist es vorteilhaft, wenn für die ermittelte Zustandsgröße ein Vergleichswert bereitgestellt ist. Die Auswerteeinheit kann dann die ermittelte Zustandsgröße mit dem Vergleichswert beziehungsweise auch mit zuvor ermittelten Zustandsgrößen vergleichen, um hieraus eine Information über die aktuelle Zustandsgröße gewinnen zu können. Beispielsweise kann die Auswerteeinheit auf diese Weise einen Alterungsverlauf der Batteriezelle beziehungsweise der Batterie ermitteln.

Ferner wird vorgeschlagen, dass mittels des Auswertens eine elektrische Kapazität und/oder ein elektrischer Widerstand zwischen den elektrisch leitfähigen Flächen ermittelt werden. Dadurch ist es möglich, die gewünschte Zustandsgröße mittels der Auswerteeinheit zuverlässig ermitteln zu können. Die Berücksichtigung des elektrischen Widerstands erlaubt es darüber hinaus, eine Aussage über eine Isolation und/oder dergleichen zu erhalten. Aus der Veränderung des elektrischen Widerstands kann ferner ergänzend auf die Alterung geschlossen werden. Zu diesem Zweck kann die Auswerteeinheit einen Wert des elektrischen Widerstands zur Ermittlung der Alterung oder einer sonstigen Qualitätsgröße berücksichtigen.

Weiterhin wird vorgeschlagen, dass bei einer Batterie mit mehr als zwei Batteriezellen zwischen allen benachbart angeordneten Batteriezellen jeweils elektrisch leitfähige Flächen angeordnet werden, wobei die mit der elektrischen Spannung zu beaufschlagenden elektrisch leitfähigen Flächen gemäß einer Überwachungsvorschrift ausgewählt werden. Diese Ausgestaltung erlaubt es, beliebige Kombinationen von elektrisch leitfähigen Flächen für die Überwachung der Batteriezellen gemäß der Überwachungsvorschrift zu nutzen. Beispielsweise ist es möglich, jeweils paarweise elektrisch leitfähige Flächen unterschiedlicher Batteriezellen gemeinsam mit der elektrischen Spannung zu beaufschlagen. Dadurch kann bereits mit einer einzelnen Messung eine Aussage über einen Qualitätszustand sämtlicher Batteriezellen der Batterie erreicht werden. Natürlich kann dies auch lediglich für eine vorgegebene Anzahl von Batteriezellen ausgeführt werden. Diese Informationen können beispielsweise der Überwachungsvorschrift entnommen werden. Die Überwachungsvorschrift als solche kann beispielsweise eine Datei sein, die die entsprechenden Informationen beziehungsweise Daten abrufbar für die Auswerteeinheit bereithält. Darüber hinaus kann natürlich auch vorgesehen sein, dass die Überwachungsvorschrift beziehungsweise deren Daten über ein Kommunikationsnetzwerk, bei einem Kraftfahrzeug beispielsweise ein CAN-BUS, ein LIN-BUS, ein Flexray-BUS oder dergleichen, abgerufen werden können. Darüber hinaus besteht natürlich die Möglichkeit, die Überwachungsvorschrift beziehungsweise entsprechende Daten auch über ein globales Kommunikationsnetzwerk, beispielsweise dem Internet oder dergleichen, abzurufen. Weiterhin kann vorgesehen sein, dass die Überwachungsvorschrift beziehungsweise eine entsprechende Datei in der Auswerteeinheit gespeichert wird. Je nach Bedarf kann vorgesehen sein, dass die Datei entsprechend aktualisiert wird.

Eine weitere Ausgestaltung der Erfindung schlägt vor, dass die elektrisch leitfähige Fläche segmentiert aus mehreren voneinander elektrisch isolierten Flächenbereichen gebildet wird, wobei die Flächenbereiche unabhängig voneinander mit der elektrischen Spannung beaufschlagt werden. Diese Ausgestaltung erlaubt es, lokale Bereiche der Begrenzungsfläche hinsichtlich einer Veränderung erfassen zu können. Diese Ausgestaltung erweist sich daher insbesondere dann als vorteilhaft, wenn bereits besonders kleine Änderungen erfasst werden sollen, die sich beispielsweise lediglich in einem Flächenbereich finden. Dadurch kann die Genauigkeit insgesamt weiter verbessert werden. Darüber hinaus lassen sich hierdurch ergänzende Informationen gewinnen, die für die Ermittlung der Zustandsgröße in Betracht gezogen werden können.

Die elektrisch leitfähigen Flächen können beispielsweise als Metallisierung an der Begrenzungsfläche angebracht sein. Es kann aber auch vorgesehen sein, dass eine Metallfolie mittels eines Verbindungsverfahrens wie Kleben oder dergleichen mit der Begrenzungsfläche verbunden ist. Weiterhin besteht natürlich die Möglichkeit, die elektrisch leitfähige Fläche durch eine Kunststofffolie mit einer hinreichend großen elektrischen Leitfähigkeit auszubilden. Eine solche Folie kann entweder die Begrenzungsfläche selbst bilden oder auf ihr aufgebracht sein. Das Gleiche gilt dem Grunde nach auch für die segmentierte Ausbildung der elektrisch leitfähigen Fläche. Besonders vorteilhaft ist jeder Flächenbereich der segmentierten elektrisch leitfähigen Fläche einzeln mit einem elektrischen Potential beaufschlagbar, sodass eine lokale Zustandsgröße ermittelt werden kann. Natürlich kann vorgesehen sein, dass lediglich eine von den beiden elektrisch leitfähigen Flächen segmentiert ausgebildet ist. Hierdurch kann der Aufwand für eine segmentierte Ausgestaltung reduziert werden. Besonders vorteilhaft erweist es sich jedoch, wenn die beiden gegenüberliegenden elektrisch leitfähigen Flächen segmentiert ausgebildet sind, wobei sie vorzugsweise eine entsprechende Segmentierung aufweisen. Dadurch lässt sich eine hohe Erfassungsgenauigkeit erreichen.

Weitere Vorteile und Merkmale ergeben sich anhand der folgenden Beschreibung von Ausführungsbeispielen unter Berücksichtigung der beigefügten Figuren. In den Figuren bezeichnen gleiche Bezugszeichen gleiche Merkmale und Funktionen.

Es zeigen:
- Fig. 1: in einer schematisch-perspektivischen Ansicht einen Ausschnitt einer ersten Ausgestaltung für eine Batteriezelle mit Batteriezellen gemäß der Erfindung,
- Fig. 2: eine schematische Schaltbildansicht der Anordnung gemäß Fig. 1, und
- Fig. 3: eine schematisch-perspektivische Ansicht einer zweiten Ausgestaltung einer Batterie mit Batteriezellen gemäß der Erfindung.

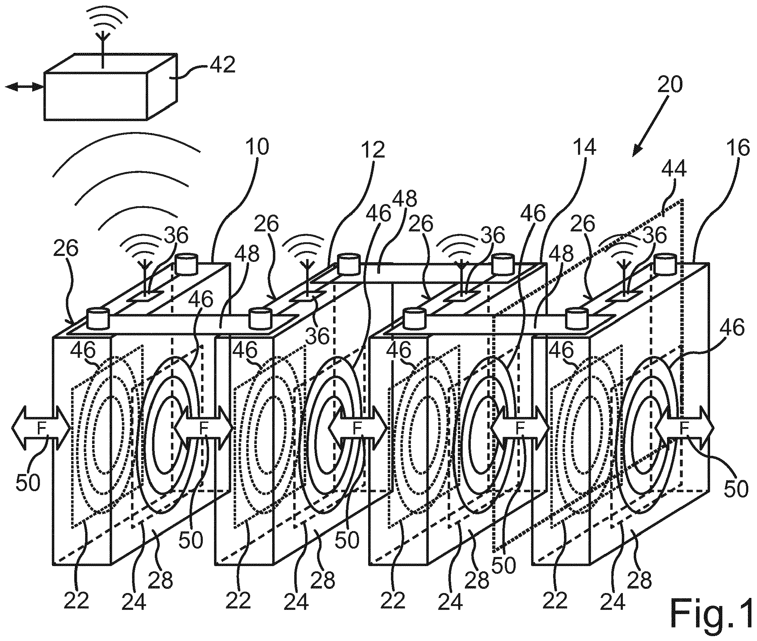

Fig. 1 zeigt in einer schematisch-perspektivischen Ansicht einen Ausschnitt aus einer Batterie 20 mit benachbart zueinander angeordneten Batteriezellen, von denen lediglich ausschnittsweise die Batteriezellen 10, 12, 14 und 16 beispielhaft dargestellt sind. In der vorliegenden Ausgestaltung ist die Batterie 20 ein Akkumulator, der in einem nicht dargestellten Kraftfahrzeug Bestandteil von dessen elektrischer Anlage ist und zur elektrischen Energieversorgung eines elektrischen Antriebs des Kraftfahrzeugs dient.

Die Batteriezellen 10, 12, 14, 16 sind vorliegend in Reihenschaltung geschaltet und entsprechend mit Stromschienen 48 elektrisch leitend verbunden. Jede der Batteriezellen 10, 12, 14, 16 ist vorliegend als Lithium-Ionen-Zelle ausgebildet und weist eine im Wesentlichen quaderförmige äußere Struktur auf. Die quaderförmige Struktur stellt gegenüberliegende seitliche Begrenzungsflächen 26, 28 bereit. Die Begrenzungsflächen 26, 28 sind vorliegend aus einem elektrisch isolierenden Werkstoff gebildet, vorliegend ein Kunststoff. Auf den Begrenzungsflächen 26, 28 sind jeweils eine erste und eine zweite elektrisch leitfähige Fläche 22, 24 mittels einer Klebeverbindung aufgebracht. Die elektrisch leitfähigen Flächen 22, 24 sind elektrisch isoliert voneinander angeordnet, und zwar nicht nur bezogen auf die jeweilige Batteriezelle 10, 12, 14, 16, sondern auch bezogen auf die jeweils gegenüberliegende elektrisch leitfähige Fläche 22, 24 der jeweiligen benachbarten Batteriezellen 10, 12, 14, 16. Vorliegend ist vorgesehen, dass zwischen den gegenüberliegenden elektrisch leitfähigen Flächen 22, 24 benachbarter Batteriezellen 10, 12, 14, 16 jeweils eine elektrisch isolierende Folie 44 aus einem Isolierwerkstoff, vorliegend Polyamid, angeordnet ist. In der vorliegenden Ausgestaltung ist vorgesehen, dass die Begrenzungsflächen 26, 28 mit den jeweiligen elektrisch leitfähigen Flächen 22, 24 benachbarter Batteriezellen 10, 12, 14, 16 unmittelbar über die jeweilige Isolierfolie 44 aneinander angrenzen.

Über nicht dargestellte elektrische Anschlüsse sind die elektrisch leitfähigen Flächen 22, 24 einer jeweiligen der Batteriezellen 10, 12, 14, 16 an eine Überwachungseinrichtung 36 der jeweiligen Batteriezelle 10, 12, 14, 16 angeschlossen. Die jeweilige Überwachungseinrichtung 36 stellt einen Spannungsgenerator sowie eine nicht weiter dargestellte Auswerteeinheit bereit, mittels denen die Wirkung einer Spannungsbeaufschlagung gegenüberliegender elektrisch leitfähiger Flächen 22, 24 benachbarter Batteriezellen 10, 12, 14, 16 ermittelt werden kann. Nicht dargestellt ist in der Ausgestaltung nach Fig. 1 der Spannungsgenerator, der jeweils paarweise gegenüberliegende elektrisch leitfähige Flächen 22, 24 benachbarter Batteriezellen 10, 12, 14, 16 mit einem Spannungsimpuls beaufschlagt. Über eine ebenfalls nicht dargestellte Schalteinrichtung kann der Spannungsimpuls auf beliebige gegenüberliegende elektrisch leitfähige Flächen 22, 24 angelegt werden.

Die Überwachungseinrichtungen 36 veranlassen den Spannungsgenerator, eine entsprechende Spannung an ein jeweils ausgewähltes Paar von elektrisch leitfähigen Flächen 22, 24 anzulegen. Die Überwachungseinrichtungen 36 der Batteriezellen 10, 12, 14, 16 stehen über Nahfunk miteinander in Kommunikationsverbindung, vorliegend gemäß einem WLAN-Standard. Alternativ kann in einer anderen Ausführungsform auch eine leitungsgebundene Kommunikationsverbindung vorgesehen sein, beispielsweise wenn die Randbedingungen eine zuverlässige Kommunikationsverbindung über Funk nicht erlauben. Darüber hinaus kann natürlich auch ein anderes Medium als Funk für eine drahtlose Kommunikationsverbindung vorgesehen sein, beispielsweise basierend auf Ultraschall, Infrarot oder dergleichen. Auch Kombinationen hiervor können vorgesehen sein.

Die Überwachungseinrichtungen 36 tauschen über die Kommunikationsverbindung ihre Daten aus. Dadurch kann aufgrund der Spannungsbeaufschlagung ein Stromfluss als durch die Einwirkung der elektrischen Spannung erzeugte elektrische Größe ermittelt werden, aus dem sodann eine Zustandsgröße aufgrund des Auswertens ermittelt wird. Vorliegend ist die Zustandsgröße eine Volumenänderung über die Lebensdauer der Batterie 20 beziehungsweise der Batteriezellen 10, 12, 14, 16. Die Überwachungseinrichtungen 36 stehen ferner in Kommunikationsverbindung mit einem Batteriemanagementsystem 42, welches seinerseits an einen nicht dargestellten CAN-BUS des Kraftfahrzeugs angeschlossen ist.

Zu diesem Zweck nutzt die Erfindung die Bestimmung der Kapazität eines durch die gegenüberliegenden elektrisch leitfähigen Flächen 22, 24 benachbarter Batteriezellen 10, 12, 14, 16 gebildeten Plattenkondensators. Durch die aktive Bestimmung von dessen elektrischer Kapazität zwischen den Batteriezellen 10, 12, 14, 16 besteht die Möglichkeit, dass einerseits auf die Qualität der Isolierfolie 44 zwischen den Batteriezellen 10, 12, 14, 16 rückgeschlossen werden kann. Vorliegend ist die elektrische Kapazität im Wesentlichen durch den Abstand der elektrisch leitfähigen Flächen 22, 24 sowie das durch die Isolierfolie 44 gebildete Dielektrikum definiert. Andererseits kann unter anderem auf ein Volumenänderungsverhalten, insbesondere Ausbauchverhalten der Batteriezellen 10, 12, 14, 16 beziehungsweise auf eine mögliche Veränderung der Isolierfolie 44 zwischen den Batteriezellen 10, 12, 14, 16 über die Lebensdauer hinweg geschlossen werden beziehungsweise, es kann aktiv erfasst, gemessen und kontrolliert werden.

Über die kapazitive Kopplung zwischen den Batteriezellen 10, 12, 14, 16 kann auch noch der Abstand zwischen den Batteriezellen 10, 12, 14, 16 und somit daraus abgeleitet unter Berücksichtigung der weiteren Batteriezellennachbarn auch eine Volumenänderung der jeweiligen Batteriezellen 10, 12, 14, 16 ermittelt werden. Darüber hinaus kann hieraus ein Innendruck der jeweiligen Batteriezellen 10, 12, 14, 16 ermittelt werden.

Weiterhin erlaubt es die Erfindung, durch die Kapazitätsermittlung auf eine Kraftentwicklung zwischen den Batteriezellen 10, 12, 14, 16 zu schließen.

Darüber hinaus kann auch im Zusammenhang mit einer aktiven Balancierung der Batteriezellen 10, 12, 14, 16 und der Kapazitätsermittlung gemäß der Erfindung auf eine übertragene Energiemenge, Verlustleistungen, Wirkungsgrade und dergleichen rückgeschlossen werden.

In Fig. 1 ist eine solche Ausbauchung mittels elliptischer Kreise 46 an den jeweiligen Begrenzungsflächen 26, 28 dargestellt. Aufgrund dieser Ausbauchung entstehen Kräfte, die mit den Kraftpfeilen 50 gekennzeichnet sind. Durch die Ausbauchung ändert sich die Kapazität zwischen den elektrisch leitfähigen Flächen 22, 24 benachbarter Batteriezellen 10, 12, 14, 16, sodass mittels der jeweiligen Überwachungseinrichtungen 36 eine entsprechende Kapazitätsänderung ermittelt werden kann. Die ermittelte Kapazitätsänderung kann, wie zuvor angegeben, zur Ermittlung der jeweiligen Zustandsgröße herangezogen werden.

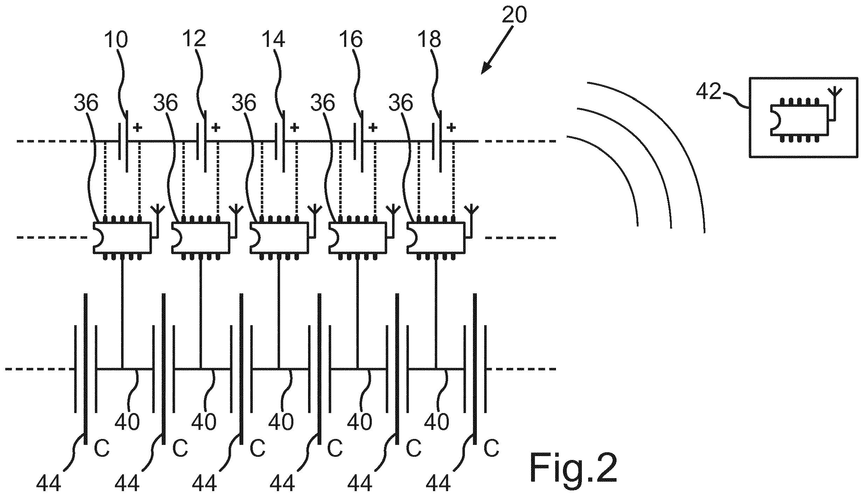

Fig. 2 zeigt eine schematische Schaltbildansicht einer Ausgestaltung der Erfindung, die auf dem Prinzip gemäß Fig. 1 basiert, wobei im Unterschied zur Ausgestaltung gemäß Fig. 1 vorliegend die Begrenzungsflächen 26, 28 durch einen Metallbecher als Gehäuse 40 bereitgestellt werden. Ferner ist eine weitere Batteriezelle 18 dargestellt, die wie die anderen Batteriezellen 10, 12, 14, 16 ausgebildet ist. Insofern sind die elektrisch leitfähigen Flächen 22, 24 einer jeweiligen der Batteriezellen 10, 12, 14, 16, 18jeweils elektrisch leitend mit einander verbunden und durch die Isolierfolien 44 durch die entsprechenden elektrisch leitfähigen Flächen 22, 24 benachbarter Batteriezellen 10, 12, 14, 16, 18 elektrisch isoliert angeordnet. Auch hier sind die Gehäuse 40 an die jeweiligen Überwachungseinrichtungen 36 angeschlossen, die vorliegend nicht nur der Auswertung dienen, sondern zusätzlich auch weitere Zustandsgrößen der jeweiligen Batteriezellen 10, 12, 14, 16, 18 erfassen. Auch hier stehen die Überwachungseinrichtungen 36 wieder über Nahfunk miteinander in Kommunikationsverbindung sowie ebenfalls über Funk in Kommunikationsverbindung mit einem Batteriemanagementsystem 42, welches seinerseits an einen nicht dargestellten CAN-BUS des Kraftfahrzeugs angeschlossen ist.

In der Ausgestaltung gemäß Fig. 2 sind die Gehäuse 40 von den Elektroden und ihren jeweiligen Anschlusskontakten der Batteriezellen 10, 12, 14, 16, 18 elektrisch isoliert angeordnet.

Auch wenn vorliegend gemäß Fig. 2 eine elektrische Isolation der Gehäuse 40 gegenüber den Elektroden beziehungsweise elektrischen Anschlusskontakten der jeweiligen der Batteriezellen 10, 12, 14, 16, 18 vorgesehen ist, kann in alternativen Ausgestaltungen natürlich auch vorgesehen sein, dass eine der Elektroden mit dem Gehäuse elektrisch leitend verbunden ist. In diesem Fall können dann auf dem Gehäuse 40 jeweils elektrisch leitfähige Flächen 22, 24, wie zu Fig. 1 erläutert, aufgebracht sein.

Die elektrisch leitfähigen Flächen können dem Grunde nach durch eine Metallisierung gebildet sein, die auf die jeweilige Begrenzungsfläche 26, 28 aufgebracht ist. Darüber hinaus besteht natürlich die Möglichkeit, die elektrisch leitfähigen Flächen 22, 24 auch durch elektrisch leitfähige Folien bereitzustellen, die auf die jeweilige Begrenzungsfläche 26, 28 aufgebracht ist beziehungsweise mit dieser befestigt ist. Beispielsweise kann eine Metallfolie oder eine elektrisch leitfähige Kunststofffolie vorgesehen sein, um die elektrisch leitfähige Fläche 22, 24 zu bilden. Diese Folie ist vorzugsweise auf die jeweilige Begrenzungsfläche 26, 28 aufgeklebt oder dergleichen befestigt. Natürlich können auch Kombinationen hiervon vorgesehen sein.

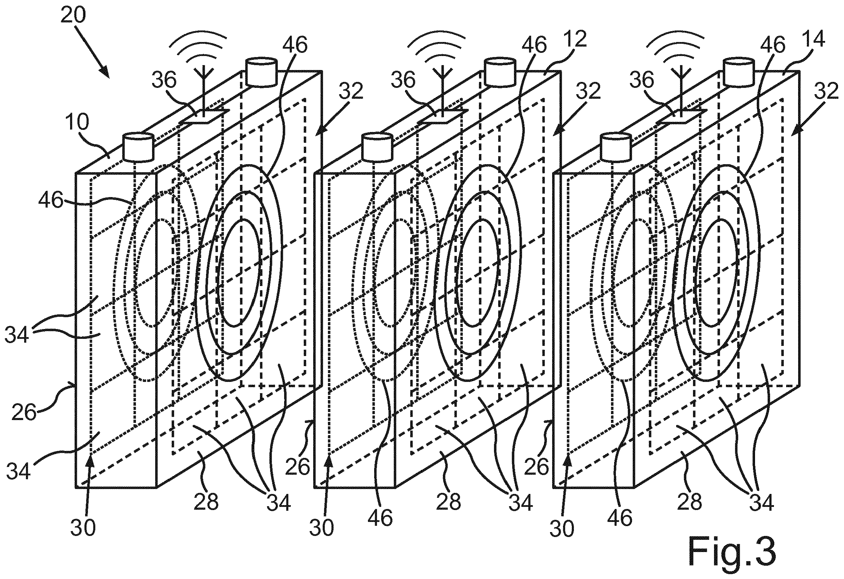

Fig. 3 zeigt eine weitere Ausgestaltung der Erfindung, wobei in Fig. 3 in einer schematisch-perspektivischen Ansicht ein Ausschnitt aus einer Batterie 20 mit Batteriezellen 10, 12, 14 dargestellt ist. Dem Grunde nach basiert die Ausgestaltung gemäß Fig. 3 auf der von Fig. 1, weshalb ergänzend auf die Ausführungen zum Ausführungsbeispiel gemäß Fig. 1 verwiesen wird. Im Folgenden werden lediglich die Unterschiede zu dem vorhergehenden Ausführungsbeispiel gemäß Fig. 1 erläutert.

Im Unterschied zum Ausführungsbeispiel gemäß Fig. 1 ist bei diesem Ausführungsbeispiel gemäß Fig. 3 vorgesehen, dass die elektrisch leitfähigen Flächen 22, 24 segmentiert sind und mehrere voneinander elektrisch isolierte Flächenbereiche 34 bilden. Die elektrisch leitfähigen Flächen sind hier mit den Bezugszeichen 30 und 32 bezeichnet. Dem Grunde nach entsprechen sie den elektrisch leitfähigen Flächen 22, 24, wie sie zur Fig. 1 erläutert worden sind.

Die elektrisch leitfähigen Flächenbereiche 34 sind gegenüber einander elektrisch isoliert angeordnet. Vorliegend ist vorgesehen, dass jeder dieser Flächenbereiche 34 separat an ein elektrisches Potential des elektrischen Spannungsgenerators angeschlossen werden kann. Es ist daher möglich, flächenselektiv die Ermittlung der Zustandsgröße durchzuführen. Insbesondere kann flächenselektiv eine Kapazitätsermittlung erfolgen, sodass insgesamt eine Ortsauflösung in der Fläche der Begrenzungsflächen 26, 28 erreicht werden kann. Dadurch kann eine Geometrie einer Volumenänderung, insbesondere einer Ausbauchung, genau ermittelt werden, wodurch die Genauigkeit der Ermittlung der jeweiligen Zustandsgröße verbessert werden kann.

Insbesondere erlaubt es die Erfindung dadurch, beginnend mit einer Inbetriebnahme einen jeweiligen Alterungszustand und daraus auch einen jeweiligen Austauschzustand zu ermitteln, bei dem eine jeweilige der Batteriezellen 10, 12, 14, 16, 18 der Batterie 20 ausgetauscht werden soll. Dadurch kann ein Qualitätszustand der Batterie 20 beziehungsweise der Batteriezellen 10, 12, 14, 16, 18 ermittelt und/oder überwacht werden.

Auch wenn die Erfindung anhand von Batterien beziehungsweise Kraftfahrzeugen erläutert worden ist, ist es für den Fachmann klar, dass die Anwendung der Erfindung nicht auf diese Anwendungen beschränkt ist. Die Erfindung kann natürlich auch bei stationären elektrischen Anlagen, insbesondere auch im Bereich von elektrischen Schaltanlagen, zum Einsatz kommen. Gerade hier kommt der erfindungsgemäße Vorteil besonders deutlich hervor, insbesondere dann, wenn die Erfindung bei unterbrechungsfreien Energieversorgungen, insbesondere für sicherheitsrelevante Funktionen eingesetzt wird. Dies ist besonders bei elektrischen Anlagen in der Signaltechnik beziehungsweise der Kommunikationstechnik von großem Vorteil.

Die Beschreibung der Ausführungsbeispiele dient lediglich der Erläuterung der Erfindung und ist für diese nicht beschränkt.

Die für die erfindungsgemäße Vorrichtung und das erfindungsgemäße Kraftfahrzeug beschriebenen Vorteile und Merkmale sowie Ausführungsformen gelten gleichermaßen für entsprechende Verfahren und umgekehrt. Folglich können für Vorrichtungsmerkmale entsprechende Verfahrensmerkmale und umgekehrt vorgesehen sein.

## Patentansprüche

1. Verfahren zum Überwachen einer Zustandsgröße wenigstens einer Batteriezelle (10, 12, 14, 16, 18) einer Batterie (20), wobei sich ein Ändern der Zustandsgröße auf eine Geometrie der Batteriezelle (10, 12, 14, 16, 18) beziehungsweise der Batterie (20) auswirkt, wobei die Batterie (20) wenigstens zwei benachbart zueinander angeordnete Batteriezellen (10, 12, 14, 16, 18) aufweist, mit folgenden Schritten:
- Vorsehen von einer ersten elektrisch leitfähigen Fläche (22) an einer Begrenzungsfläche (26) einer ersten der wenigstens zwei Batteriezellen (10, 12, 14, 16, 18) und Vorsehen einer zweiten elektrisch leitfähigen Fläche (24) an einer Begrenzungsfläche (28) einer zweiten der wenigstens zwei Batteriezellen (10, 12, 14, 16, 18), wobei die elektrisch leitfähigen Flächen (22, 24) zum kapazitiven Ermitteln der Änderung der Geometrie elektrisch isoliert voneinander angeordnet werden,
- Anlegen einer elektrischen Spannung zwischen den beiden elektrisch leitfähigen Flächen (22, 24),
- Auswerten einer aufgrund einer Einwirkung der elektrischen Spannung erzeugten elektrischen Größe, und
- Ermitteln der Zustandsgröße aufgrund des Auswertens.

2. Verfahren nach Anspruch 1, **dadurch gekennzeichnet, dass** die ermittelte Zustandsgröße mit einem Vergleichswert verglichen wird.

3. Verfahren nach Anspruch 1 oder 2, **dadurch gekennzeichnet, dass** mittels des Auswertens eine elektrische Kapazität und/oder ein elektrischer Widerstand zwischen den elektrisch leitfähigen Flächen (22, 24) ermittelt wird.

4. Verfahren nach einem der Ansprüche 1 bis 3, **dadurch gekennzeichnet, dass** die elektrische Spannung durch einen oder mehrere Spannungsimpulse gebildet wird.

5. Verfahren nach einem der Ansprüche 1 bis 4, **dadurch gekennzeichnet, dass** die elektrische Spannung durch eine Wechselspannung gebildet wird.

6. Verfahren nach einem der Ansprüche 1 bis 5, **dadurch gekennzeichnet, dass** bei einer Batterie (20) mit mehr als zwei Batteriezellen (10, 12, 14, 16, 18) zwischen allen benachbart angeordneten Batteriezellen (10, 12, 14, 16, 18) jeweils elektrisch leitfähige Flächen (22, 24) angeordnet werden, wobei die mit der elektrischen Spannung zu beaufschlagenden elektrisch leitfähigen Flächen (22, 24) gemäß einer Überwachungsvorschrift ausgewählt werden.

7. Verfahren nach einem der Ansprüche 1 bis 6, **dadurch gekennzeichnet, dass** die elektrisch leitfähige Fläche (30, 32) segmentiert aus mehreren voneinander elektrisch isolierten Flächenbereichen (34) gebildet wird, wobei die Flächenbereiche (34) unabhängig voneinander mit der elektrischen Spannung beaufschlagt werden.

8. Überwachungseinrichtung (36) zum Überwachen einer Zustandsgröße wenigstens einer Batteriezelle (10, 12, 14, 16, 18) einer Batterie (20), wobei sich ein Ändern der Zustandsgröße auf eine Geometrie der Batteriezelle (10, 12, 14, 16, 18) beziehungsweise der Batterie (20) auswirkt, wobei die Batterie (20) wenigstens zwei benachbart zueinander angeordnete Batteriezellen (10, 12, 14, 16, 18) aufweist,
**dadurch gekennzeichnet,**
**dass** die Überwachungseinrichtung (36) ausgebildet ist, eine elektrische Spannung zwischen einer ersten elektrisch leitfähigen Fläche (22), die an einer Begrenzungsfläche (26) einer ersten der wenigstens zwei Batteriezellen (10, 12, 14, 16, 18) vorgesehen ist, und einer zweiten elektrisch leitfähigen Fläche (24), die an einer Begrenzungsfläche (28) einer zweiten der wenigstens zwei Batteriezellen (10, 12, 14, 16, 18) elektrisch isoliert von der ersten elektrisch leitfähigen Fläche (22) vorgesehen ist, um kapazitiv die Änderung der Geometrie zu ermitteln, anzulegen, eine aufgrund einer Einwirkung der elektrischen Spannung erzeugte elektrische Größe auszuwerten und die Zustandsgröße aufgrund des Auswertens zu ermitteln.

9. Batterie (20) mit wenigstens zwei benachbart zueinander angeordneten Batteriezellen (10, 12, 14, 16, 18),
**dadurch gekennzeichnet,**
**dass** eine Begrenzungsfläche (26) einer ersten der wenigstens zwei Batteriezellen (10, 12, 14, 16, 18) eine erste elektrisch leitfähige Fläche (22) und eine Begrenzungsfläche (28) einer zweiten der wenigstens zwei Batteriezellen (10, 12, 14, 16, 18) eine zweite elektrisch leitfähige Fläche (24) aufweist, wobei die elektrisch leitfähigen Flächen (22, 24) elektrisch isoliert voneinander angeordnet sind, um kapazitiv die Änderung der Geometrie zu ermitteln, wobei die Batterie (20) eine Überwachungseinrichtung (36) zum Überwachen einer Zustandsgröße wenigstens einer Batteriezelle (10, 12, 14, 16, 18) der Batterie (20) aufweist, wobei sich ein Ändern der Zustandsgröße auf eine Geometrie der Batteriezelle (10, 12, 14, 16, 18) beziehungsweise der Batterie (20) auswirkt, wobei die Überwachungseinrichtung (36) ausgebildet ist, eine elektrische Spannung zwischen den beiden elektrisch leitfähigen Flächen (22, 24) anzulegen, eine aufgrund einer Einwirkung der elektrischen Spannung erzeugte elektrische Größe auszuwerten und die Zustandsgröße aufgrund des Auswertens zu ermitteln.

10. Batterie nach Anspruch 9, **dadurch gekennzeichnet, dass** die Batteriezellen (10, 12, 14, 16, 18) in jeweils einem elektrisch leitfähigen Gehäuse (40) angeordnet sind und die elektrisch leitfähigen Flächen (22, 24) durch die Gehäuse (40) der Batteriezellen (10, 12, 14, 16, 18) gebildet sind.

11. Kraftfahrzeug mit einer elektrischen Antriebsvorrichtung und mit einer an die elektrische Antriebsvorrichtung angeschlossenen elektrischen Anlage zum Versorgen der elektrischen Antriebsvorrichtung mit elektrischer Energie, die eine Batterie (20) aufweist, die wenigstens zwei benachbart zueinander angeordnete Batteriezellen (10, 12, 14, 16, 18) aufweist,
**dadurch gekennzeichnet,**
**dass** eine Begrenzungsfläche (26) einer ersten der wenigstens zwei Batteriezellen (10, 12, 14, 16, 18) eine erste elektrisch leitfähige Fläche (22) und eine Begrenzungsfläche (28) einer zweiten der wenigstens zwei Batteriezellen (10, 12, 14, 16, 18) eine zweite elektrisch leitfähige Fläche (24) aufweist, wobei die elektrisch leitfähigen Flächen (22, 24) elektrisch isoliert voneinander angeordnet sind, um kapazitiv die Änderung der Geometrie zu ermitteln, wobei die Batterie (20) eine Überwachungseinrichtung (36) zum Überwachen einer Zustandsgröße wenigstens einer Batteriezelle (10, 12, 14, 16, 18) der Batterie (20) aufweist, wobei sich ein Ändern der Zustandsgröße auf eine Geometrie der Batteriezelle (10, 12, 14, 16, 18) beziehungsweise der Batterie (20) auswirkt, wobei die Überwachungseinrichtung (36) ausgebildet ist, eine elektrische Spannung zwischen den beiden elektrisch leitfähigen Flächen (22, 24) anzulegen, eine aufgrund einer Einwirkung der elektrischen Spannung erzeugte elektrische Größe auszuwerten und die Zustandsgröße aufgrund des Auswertens zu ermitteln.

## Claims

1. Method for monitoring a state variable of at least one battery cell (10, 12, 14, 16, 18) of a battery (20), wherein changing the state variable has an effect on the geometry of the battery cell (10, 12, 14, 16, 18) or the battery (20), wherein the battery (20) has at least two battery cells (10, 12, 14, 16, 18) that are arranged adjacent to one another, with the following steps:
- providing a first electrically conductive surface (22) at a boundary surface (26) of a first of the at least two battery cells (10, 12, 14, 16, 18) and providing a second electrically conductive surface (24) at a boundary surface (28) of a second of the at least two battery cells (10, 12, 14, 16, 18), wherein the electrically conductive surfaces (22, 24) are arranged to be electrically insulated from each other for the capacitive determination of the change of geometry,
- applying an electrical voltage between the two electrically conductive surfaces (22, 24),
- analysing an electrical variable produced due to an effect of the electrical voltage and
- determining the state variable on the basis of the analysis.

2. Method according to claim 1, **characterised in that** the determined state variable is compared with a reference value.

3. Method according to claim 1 or 2, **characterised in that** an electrical capacitance and/or an electrical resistance between the electrically conductive surfaces (22, 24) is determined by means of the analysis.

4. Method according to any of claims 1 to 3, **characterised in that** the electrical voltage is formed by at least one or more voltage pulses.

5. Method according to any of claims 1 to 4, **characterised in that** the electrical voltage is formed by an alternating current voltage.

6. Method according to any of claims 1 to 5, **characterised in that** in the case of a battery (20) with more than two battery cells (10, 12, 14, 16, 18) respective electrically conductive surfaces (22, 24) are arranged between all adjacently arranged battery cells (10, 12, 14, 16, 18), wherein the electrically conductive surfaces (22, 24) to which the electrical voltage is to be applied are selected in accordance with a monitoring rule.

7. Method according to any of claims 1 to 6, **characterised in that** the electrically conductive surface (30, 32) is constructed in segments from several surface regions (34) that are electrically insulated from one another, wherein electrical voltage can be applied to the surface regions (34) independently of one another.

8. Monitoring device (36) for monitoring a state variable of at least one battery cell (10, 12, 14, 16, 18) of a battery (20), wherein a change in the state variable has an effect on a geometry of the battery cell (10, 12, 14, 16, 18) or the battery (20), wherein the battery (20) has at least two battery cells (10, 12, 14, 16, 18) that are arranged adjacent to one another,
**characterised in that**
the monitoring device (36) is designed to apply an electrical voltage between a first electrically conductive surface (22), which is provided at a boundary surface (26) of a first of the at least two battery cells (10, 12, 14, 16, 18), and a second electrically conductive surface (24), which is provided at a boundary surface (28) of a second of the at least two battery cells (10, 12, 14, 16, 18), which is electrically insulated from the first electrically conductive surface (22), to determine capacitively the change of geometry, to analyse an electrical variable produced due to an effect of the electrical voltage and to determine the state variable on the basis of the analysis.

9. Battery (20) having at least two battery cells (10, 12, 14, 16, 18) arranged adjacent to one another,
**characterised in that**
a boundary surface (26) of a first of the at least two battery cells (10, 12, 14, 16, 18) has a first electrically conductive surface (22) and a boundary surface (28) of a second of the at least two battery cells (10, 12, 14, 16, 18) has a second electrically conductive surface (24), wherein the electrically conductive surfaces (22, 24) are arranged to be electrically insulated from each other, to determine capacitively the change of geometry, wherein the battery (20) has a monitoring device (36) for monitoring a state variable of at least one battery cell (10, 12, 14, 16, 18) of the battery (20), wherein a change in the state variable has an effect on a geometry of the battery cell (10, 12, 14, 16, 18) or the battery (20), wherein the monitoring device (36) is designed to apply an electrical voltage between the two electrically conductive surfaces (22, 24), to analyse an electrical variable produced due to an effect of the electrical voltage, and to determine the state variable on the basis of the analysis.

10. Battery according to claim 9, **characterised in that** the battery cells (10, 12, 14, 16, 18) are each arranged in an electrically conductive housing (40) and the electrically conductive surfaces (22, 24) are formed by the housing (40) of the battery cells (10, 12, 14, 16, 18).

11. Motor vehicle with an electrical drive device and with an electrical system connected to the electrical drive device for supplying the electrical drive device with electrical energy, which has a battery (20) that has at least two battery cells (10, 12, 14, 16, 18) that are arranged adjacent to one another,
**characterised in that**
a boundary surface (26) of a first of the at least two battery cells (10, 12, 14, 16, 18) has a first electrically conductive surface (22) and a boundary surface (28) of a second of the at least two battery cells (10, 12, 14, 16, 18) has a second electrically conductive surface (24), wherein the electrically conductive surfaces (22, 24) are arranged to be electrically insulated from each other, to determine capacitively the change of geometry, wherein the battery (20) has a monitoring device (36) for monitoring a state variable of at least one battery cell (10, 12, 14, 16, 18) of the battery (20), wherein a change in the state variable has an effect on a geometry of the battery cell (10, 12, 14, 16, 18) or the battery (20), wherein the monitoring device (36) is designed to apply an electrical voltage between the two electrically conductive surfaces (22, 24), to analyse an electrical variable produced due to an effect of the electrical voltage and to determine the state variable on the basis of the analysis.

## Revendications

1. Procédé de surveillance d'une variable d'état d'au moins un élément de batterie (10, 12, 14, 16, 18) d'une batterie (20), dans lequel une modification de la variable d'état s'exerce sur une géométrie des éléments de batterie (10, 12, 14, 16, 18) ou bien de la batterie (20), dans lequel la batterie (20) présente au moins deux éléments de batterie (10, 12, 14, 16, 18) agencés de manière adjacente les uns par rapport aux autres, avec les étapes ci-dessous :
- fourniture d'une première surface électriquement conductrice (22) au niveau d'une surface de délimitation (26) d'un premier parmi les au moins deux éléments de batterie (10, 12, 14, 16, 18) et fourniture d'une seconde surface électriquement conductrice (24) au niveau d'une surface de délimitation (28) d'un second parmi les au moins deux éléments de batterie (10, 12, 14, 16, 18), dans lequel les surfaces électriquement conductrices (22, 24) sont agencées de manière électriquement isolée l'une de l'autre en vue d'une détermination capacitive de la modification de la géométrie,
- application d'une tension électrique entre les deux surfaces électriquement conductrices (22, 24),
- évaluation d'une variable électrique générée sous l'action de la tension électrique, et
- détermination de la variable d'état sur la base de l'évaluation.

2. Procédé selon la revendication 1, **caractérisé en ce que** la variable d'état déterminée est comparée à une valeur de comparaison.

3. Procédé selon la revendication 1 ou 2, **caractérisé en ce qu'**une capacité électrique et/ou une résistance électrique entre les surfaces électriquement conductrices (22, 24) est/sont déterminée(s) au moyen de l'évaluation.

4. Procédé selon l'une quelconque des revendications 1 à 3, **caractérisé en ce que** la tension électrique est formée grâce à une ou plusieurs impulsion(s) de tension.

5. Procédé selon l'une quelconque des revendications 1 à 4, **caractérisé en ce que** la tension électrique est formée grâce à une tension alternative.

6. Procédé selon l'une quelconque des revendications 1 à 5, **caractérisé en ce que**, pour une batterie (20) avec plus de deux éléments de batterie (10, 12, 14, 16, 18), des surfaces électriquement conductrices (22, 24) sont respectivement agencées entre tous les éléments de batterie (10, 12, 14, 16, 18) agencés de manière adjacente, dans lequel les surfaces électriquement conductrices (22, 24) à soumettre à la tension électrique sont sélectionnées conformément à une règle de surveillance.

7. Procédé selon l'une quelconque des revendications 1 à 6, **caractérisé en ce que** la surface électriquement conductrice (30, 32) est formée, de manière segmentée, de plusieurs zones de surface (34) isolées électriquement les unes des autres, dans lequel les zones de surface (34) sont soumises indépendamment les unes des autres à la tension électrique.

8. Dispositif de surveillance (36) destiné à la surveillance d'une variable d'état d'au moins un élément de batterie (10, 12, 14, 16, 18) d'une batterie (20), dans lequel une modification de la variable d'état s'exerce sur une géométrie des éléments de batterie (10, 12, 14, 16, 18) ou bien de la batterie (20), dans lequel la batterie (20) présente au moins deux éléments de batterie (10, 12, 14, 16, 18) agencés de manière adjacente les uns par rapport aux autres,
**caractérisé en ce que**
le dispositif de surveillance (36) est conçu pour appliquer une tension électrique entre une première surface électriquement conductrice (22) prévue au niveau d'une surface de délimitation (26) d'un premier parmi les au moins deux éléments de batterie (10, 12, 14, 16, 18) et une seconde surface électriquement conductrice (24) prévue au niveau d'une surface de délimitation (28) d'un second parmi les au moins deux éléments de batterie (10, 12, 14, 16, 18) et électriquement isolée de la première surface électriquement conductrice (22), afin de déterminer de manière capacitive la modification de la géométrie, pour évaluer une variable électrique générée sous l'action de la tension électrique, et pour déterminer la variable d'état sur la base de l'évaluation.

9. Batterie (20) avec au moins deux éléments de batterie (10, 12, 14, 16, 18) agencés de manière adjacente les uns par rapport aux autres,
**caractérisée en ce que**
une surface de délimitation (26) d'un premier parmi les au moins deux éléments de batterie (10, 12, 14, 16, 18) présente une première surface électriquement conductrice (22) et une surface de délimitation (28) d'un second parmi les au moins deux éléments de batterie (10, 12, 14, 16, 18) présente une seconde surface électriquement conductrice (24), dans laquelle les surfaces électriquement conductrices (22, 24) sont agencées de manière électriquement isolée l'une de l'autre pour déterminer de manière capacitive la modification de la géométrie, dans laquelle la batterie (20) présente un dispositif de surveillance (36) destiné à surveiller une variable d'état d'au moins un élément de batterie (10, 12, 14, 16, 18) de la batterie (20), dans laquelle une modification de la variable d'état s'exerce sur une géométrie des éléments de batterie (10, 12, 14, 16, 18) ou bien de la batterie (20), dans laquelle le dispositif de surveillance (36) est conçu pour appliquer une tension électrique entre les deux surfaces électriquement conductrices (22, 24), pour évaluer une variable électrique générée sous l'action de la tension électrique, et pour déterminer la variable d'état sur la base de l'évaluation.

10. Batterie selon la revendication 9, **caractérisée en ce que** les éléments de batterie (10, 12, 14, 16, 18) sont agencés dans respectivement un logement électriquement conducteur (40) et les surfaces électriquement conductrices (22, 24) sont formées à travers les logements (40) des éléments de batterie (10, 12, 14, 16, 18).

11. Véhicule automobile avec un dispositif d'entraînement électrique et avec une installation électrique raccordée au dispositif d'entraînement électrique en vue d'une alimentation du dispositif d'entraînement électrique en énergie électrique, qui présente une batterie (20) présentant au moins deux éléments de batterie (10, 12, 14, 16, 18) agencés de manière adjacente les uns par rapport aux autres,
**caractérisé en ce que**
une surface de délimitation (26) d'un premier parmi les au moins deux éléments de batterie (10, 12, 14, 16, 18) présente une première surface électriquement conductrice (22) et une surface de délimitation (28) d'un second parmi les au moins deux éléments de batterie (10, 12, 14, 16, 18) présente une seconde surface électriquement conductrice (24), dans laquelle les surfaces électriquement conductrices (22, 24) sont agencées de manière électriquement isolée l'une de l'autre pour déterminer de manière capacitive la modification de la géométrie, dans laquelle la batterie (20) présente un dispositif de surveillance (36) destiné à surveiller une variable d'état d'au moins un élément de batterie (10, 12, 14, 16, 18) de la batterie (20), dans laquelle une modification de la variable d'état s'exerce sur une géométrie des éléments de batterie (10, 12, 14, 16, 18) ou bien de la batterie (20), dans laquelle le dispositif de surveillance (36) est conçu pour appliquer une tension électrique entre les deux surfaces électriquement conductrices (22, 24), pour évaluer une variable électrique générée sous l'action de la tension électrique, et pour déterminer la variable d'état sur la base de l'évaluation.
